# EUROPEAN PATENT SPECIFICATION

(11) **EP 2 372 779 B1**
(45) Date of publication and mention of the grant of the patent: **01.10.2014**
(21) Application number: 11160212.4
(22) Date of filing: 29.03.2011
(51) Int. Cl.: H01L 31/0236, H01L 31/18

(54) **Alkaline etching liquid for texturing a silicon wafer surface**
Alkaliätzflüssigkeit zur Strukturierung einer Silicium-Waferfläche
Liquide de gravure alcalin pour texturer la surface d'une tranche de silicium

(30) Priority: 01.04.2010 US 752180; 04.11.2010 US 939193
(43) Date of publication of application: 05.10.2011
(73) Proprietor: SolarWorld Industries America, Inc., Hillsboro OR 97124 (US)
(72) Inventor: Holdermann, Konstantin, Hillsboro, OR 97124 (US)
(74) Representative: Viering, Jentschura & Partner Patent- und Rechtsanwälte

(56) References cited:
- EP-A1- 0 477 424
- EP-A2- 1 126 278
- US-A- 5 541 057
- US-A1- 2002 079 290
- US-A1- 2009 218 542

## Description

### Technical Field

Various embodiments generally relate to an etching liquid for texturing a silicon surface.

### Background

Alkaline anisotropic etching with potassium hydroxide (KOH) and the additive 2-propanol (IPA) is a widely used step to texture monocrystalline silicon wafers industrially. Texturisation of the wafers is conventionally used to reduce their reflection and thus increase the absorbed light intensity. This may lead to an increased performance of a silicon photovoltaic cell including these wafers.

Using an aqueous solution of an alkali hydroxide and 2-propanol as an etching solution, a texturing time of about 15 to 25 minutes at about 75°C is required to remove saw damage caused by wafer production and to receive a texture with complete random pyramid coverage.

Alkaline agents like potassium hydroxide and sodium hydroxide are the most commonly used etching reagents in such texturisation processes. Organic etching agents like tetramethylammonium hydroxide and ethylenediamine pyrocatechol require longer treatment times to achieve a similar etching, but they have the effect not to provide metallic cations that can interfere with the electric properties of, e.g. oxidized, silicon substrates.

This is also the reason for the preference of potassium hydroxide over sodium hydroxide, since the sodium ions which remain on the surface after texturing are more likely to interfere with the electric properties of the silicon substrate.

One effect of the currently used processes that use an alkaline agent in combination with 2-propanol (IPA) is that the IPA has to be redosed frequently in a high amount because it easily evaporates during the process.

In addition, IPA is highly flammable, toxic to human beings upon longer exposure, and waste as well as the exhausted vapor require special treatments.

However, known replacements for IPA require higher temperatures or longer etching times to achieve a similar etching result and are relatively expensive. Higher reaction temperatures mean that the process consumes more energy and instead of cost savings plastic like polypropylene equipment the more expensive stainless steel or expensive plastic equipment like Teflon has to be used for the process.

US 2009/0218542 provides an etchant composition containing (a) an alkaline compound mixture of an organic alkaline compound and inorganic alkaline compound and (b) a silicon-containing compound, whereby the organic alkaline compound is composed of one or more ingredients from quaternary ammonium hydroxide and ethylenediamine.

There is thus need in the art for an etching liquid that may partially or completely overcome the above-mentioned effects of the conventional techniques while retaining some or all of the advantages of the currently used etching solutions.

### Summary

The scope of the invention is defined by the appended claims.

### Brief Description of the Figures

FIG. 1 shows a scanning electron microscope (SEM) image of a silicon wafer surface as cut after texture etching for 15 minutes with an aqueous solution of 9 wt.-% raffinose and 3 wt.-% NaOH at 75 °C.

FIG. 2 shows an SEM image of a saw damage etched silicon wafer surface after texture etching for 15 minutes with an aqueous solution of 9 wt.-% raffinose and 3 wt.-% NaOH at 75 °C

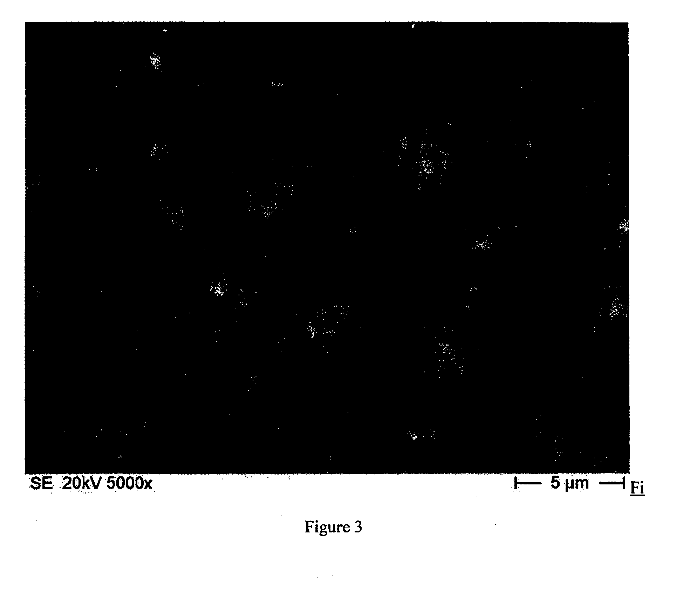

FIG. 3 shows a scanning electron microscope (SEM) image of a silicon wafer surface as cut after texture etching for 9 minutes with an aqueous solution of 0.04 wt.-% starch and 3 wt.-% KOH at 73.5 °C.

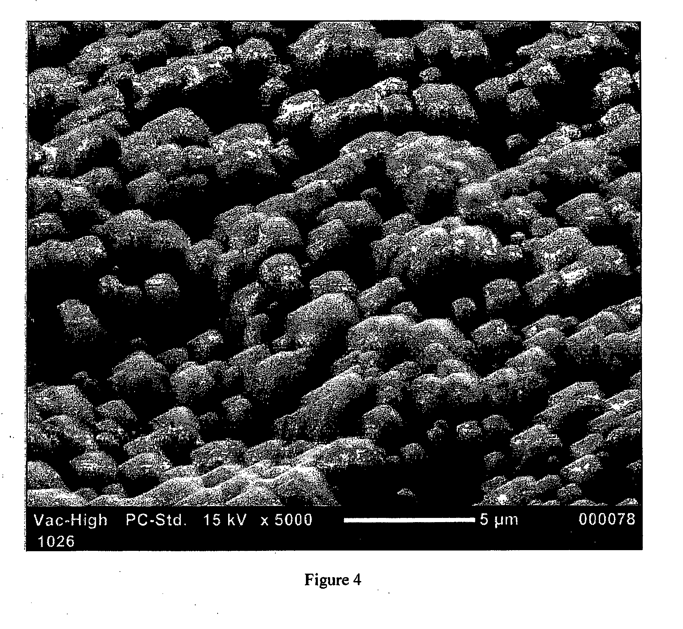

FIG. 4 shows a scanning electron microscope (SEM) image of a silicon wafer surface, that was first damage etched and then texture etched for 6 minutes with an aqueous solution of 0.004 wt.-% pectin and 3 wt.-% KOH at 73.5 °C.

### Description

The word "exemplary" is used herein to mean "serving as an example, instance, or illustration". Any embodiment or design described herein as "exemplary" is not necessarily to be construed as preferred or advantageous over other embodiments or designs.

In the context of the various embodiments, the following terms have the meaning indicated below unless explicitly indicated otherwise.

The term "liquid" as used herein in connection with the etching liquids of the invention, relates to a fluid composition, such as solutions, suspensions, and colloids, including emulsions. Preferred are aqueous solutions, colloids and suspensions. The liquids may be prepared by suspending the polysaccharide in water or in an aqueous solution with or without heating. The aqueous solution may be an alkaline solution.

The term "polysaccharide" as used herein refers to polymeric carbohydrate structures, formed of repeating units (either mono- or di-saccharides) joined together by glycosidic bonds. These structures may be linear, but may also contain various degrees of branching. The polysaccharide may be a homo- or heteropolysaccharide. The polysaccharide may contain non-carbohydrate units. Examples of polysaccharides include, but are not limited to, amylose, amylopectin, pectins, glycogen, agar, alginate, carrageenans, chitin, beta-glucans, dextrins, carboxymethylcellulose, carboxyethylcellulose, hydroxypropylcellulose, methylcellulose and combinations thereof. One exemplary combination of the afore-mentioned polysaccharides is starch which consists of amylopectin and amylose. Usually polysaccharides comprise more than 100 monosaccharide or disaccharide units, such as 200 to 2500. The molecular weight of the polysaccharides can be greater than 20,000, for example 20,000 to 1,000,000 g/mol or even higher.

Starches are polymers of D-glucose in which glucopyranose units are linked by alpha-glycosidic bonds, usually 1→4 glycosidic bonds. Starch is generally made up of a mixture of amylose (15-20%) and amylopectin (80-85%). Amylose consists of a linear chain of several hundred glucose molecules that are linked by alpha 1→4 glycosidic bonds and little or no branching. Amylopectin is a branched molecule made of several thousand glucose units that consists of multiple chains of glucose units linked by alpha 1→4 glycosidic bonds and connected by branching points via alpha 1→6 glycosidic bonds. Branching occurs usually every 25-35 glucose units.

Glycogen is a polysaccharide that is found in animals and is composed of a branched chain of glucose residues. It is very similar to amylopectin, but has a higher degree of branching (about every 10 glucose units).

Agar is a mixture of agarose and agaropectin and is mainly found in red algae. Agarose is a linear polymer, composed of repeating units of the disaccharide Agarobiose. Agaropectin is a heterogeneous mixture of smaller molecules and is branched and sulfated.

Alginate is a polysaccharide, found in brown algea as alginic acid. It is composed of blocks of β-D-mannuronate and blocks of α-L-guluronate that are (1-4)-linked.

Carrageenans is a polysaccharide that is found in red algae, and is composed of repeating galactose units and 3,6 anhydrogalactose, both contain different amounts of sulfate.

Dextrins are a group of low-molecular-weight carbohydrates produced by the hydrolysis of starch or glycogen. Dextrins are mixtures of polymers of D-glucose units linked by α-(1,4) or α-(1,6) glycosidic bonds.

Pectins are polysaccharides predominantly found in plants and contain 1,4-linked α-D-galactosyluronic acid residues. Pectins include homogalacturonans, substituted galacturonans and rhamnogalacturonans. Homogalacturonans are linear chains of α-(1-4)-linked D-galacturonic acid. Substituted galacturonans are characterized by the presence of saccharide appendant residues (such as D-xylose or D-apiose in the respective cases of xylogalacturonan and apiogalacturonan) branching from a backbone of D-galacturonic acid residues. Rhamnogalacturonan I pectins (RG-I) contain a backbone of the repeating disaccharide: α-D-galacturonic acid-(1,2)-α-L-rhamnose coupled by 1-4 glycosidic bonds. From many of the rhamnose residues, sidechains of various neutral sugars branch off. The neutral sugars are mainly D-galactose, L-arabinose and D-xylose, the types and proportions of neutral sugars varying with the origin of pectin. Another structural type of pectin is rhamnogalacturonan II (RG-II), which is a less frequent complex, highly branched polysaccharide. The rhamnogalacturonan II backbone is made exclusively of D-galacturonic acid units. Isolated pectin has a molecular weight of typically 60-130,000 g/mol, varying with origin and extraction conditions. In nature, around 80% of carboxyl groups of galacturonic acid are esterified with methanol. In purified pectin, part of or all of the esterification may be lost due to the purification conditions.

β-Glucans (beta-glucans) are polysaccharides of D-glucose monomers linked by β-glycosidic bonds. β-glucans are a diverse group of molecules that can vary with respect to molecular mass, solubility, viscosity, and three-dimensional configuration. One example of a beta-glucan, is cellulose.

Chitin consists of units of *N*-acetylglucosamine (2-(acetylamino)-2-deoxy-D-glucose) linked by covalent β-1,4 linkages to form a linear chain.

The polysaccharides may be derived from any suitable source, such as plants or animals, but also fungi or bacteria.

The term "polyalcohol" as used herein refers to an organic compound that includes more than one hydroxy group. The basic structure of the polyalcohol may be an alkane, alkene, alkine, cycloalkane, cycloalkene, aryl or heteroaryl which may be substituted with other functional groups, such as carbonyl, primary, secondary and tertiary amine, sulfonyl, phosphonyl, carboxy, and the like.

The term "hydroxy group" or "hydroxyl group" as interchangeably used herein refers to an -OH group.

The term "carbohydrate" as used herein refers to sugars and may include monosaccharides, disaccharides, trisaccharides, oligosaccharides, and polysaccharides. Disaccarides, trisaccharides, oligosaccharides and polysaccharides comprise two, three or more monosaccharide units that are linked by a covalent (glycosidic) bond. Exemplary monosaccharides include but are not limited to erythrose, threose, erythrulose, ribose, arabinose, xylose, lyxose, ribulose, xylulose, allose, altrose, glucose, mannose, gulose, idose, galactose, talose, psicose, fructose, sorbose and tagatose.

The term "non-reducing sugar" as used herein refers to a disaccharide, trisaccharide, oligosaccharide or polysaccharide that has no reducing activity, i.e. that cannot act as a reducing agent, for example in the Maillard reaction, Benedict's reaction or Fehling's reaction. Non-reducing sugars are di-, tri, oligo- or polysaccharides wherein the anomeric carbon atoms of all monosaccharide units are blocked by a glycosidic bond and include, but are not limited to sucrose, trehalose and raffinose.

The expression "reducing sugar" as used herein relates to any sugar that acts as a reducing agent, for example in the Maillard reaction, Benedict's reaction or Fehling's reaction. Reducing sugars are those sugars in which the anomeric carbon atom of one or more monosaccharide units (the carbon which is linked to two oxygen atoms) is in the free form, i.e. does not form part of a glycosidic bond. This allows the sugar to convert into the linear aldehyde or ketone (i.e. the chain-form), where the aldehyde group can be oxidized to a carboxyl group via a redox reaction.

The term "sugar alcohol" as used herein relates to polyalcohols that are derived from carbohydrates by reduction of the aldehyde or keto group. Sugar alcohols include, but are not limited to sorbitol (glucitol), mannitol, xylitol, maltitol, lactitol, erythritol, arabitol, isomalt, threitol, ribitol, dulcitol, iditol, and polyglycitol.

The term "sugar acid" as used herein relates to a hydroxy carboxylic acid that is derived from a sugar by oxidizing the aldehyde group. Exemplary sugar acids may include aldonic and uronic acids, such as xylonic acid, gluconic acid, ascorbic acid, glucuronic acid, galacturonic acid, iduronic acid, tataric acid, mucic acid and saccharic acid.

The expression "derivative", as used herein in connection with the polysaccharides and polyalcohols of various embodiments, relates to a compound that differs from the corresponding polysaccharide or polyalcohol in that at least one of the hydroxy groups is replaced by another group. In case of polyalcohols, such a group may, for example, be an oxo (=O) group, and thus include aldehydes, ketones, carboxylic acids, amides, and the like. Exemplary derivatives of polyalcohols are aldehydes, ketones and carboxylic acids that include one or more hydroxy groups. Exemplary derivatives of polysaccharides are those wherein the hydrogen atom of one or more hydroxy groups is replaced by an alkyl or acetyl group or the hydroxy group is replaced by a carboxy or amide group or the like.

The term "about" as used herein in combination with a numeric value means that the given value can vary in a range of about ± 20 %, preferably about ± 10 % relative to the given numeric value.

Various embodiments are based on the inventor's finding that in an alkaline etching liquid for texture etching a silicon wafer surface, the 2-propanol additive can be replaced by a a carbohydrate or derivative thereof, such as a polysaccharide or derivative thereof, without impairing the etching efficiency of the solution. These solutions have the effect that the utilized carbohydrates or derivatives can even be used at temperature over 90 °C without evaporating compared to 2-propanol. In addition, they are inexpensive, non-toxic and not highly flammable, but still provide for fast and efficient etching at a temperature between 70 and 80 °C so that cost effective plastic equipment can be used for the etching process instead of the more expensive stainless steel- or Teflon- equipment necessary if higher temperatures are employed. Using these etching liquids, the etching temperature can even be reduced to a temperature as low as 55 or 60 °C with etching still being highly efficient, thus being significantly less energy-consuming. In addition, the inventor has found that these additives can be used in very low concentrations, as low as only 0.001 % by weight of the etching liquid, while still maintaining etching efficiency. Moreover, these types of additives are safe under environmental aspects. Finally, the inventor has found that using different carbohydrates, such as polysaccharides and disaccharides, in combination has a synergistic effect with respect to the etching efficiency and allows rapid etching of silicon wafers at comparably low temperatures.

Various embodiments thus feature an etching liquid for texturing a silicon surface, for example a silicon wafer surface, including an aqueous solution, colloid or suspension of at least one alkaline etching agent and (i) at least one polysaccharide or derivative thereof, and/or (ii) at least one polyalcohol comprising at least four hydroxy groups or a derivative thereof.

The polysaccharide is selected from the group consisting of amylose, amylopectin, glycogen, agar, alginate, carrageenans, pectins, chitin, beta-glucans, dextrins, carboxymethylcellulose, carboxyethylcellulose, hydroxypropylcellulose, methylcellulose and combinations thereof and/or the etching liquid contains about 0.001 to about 0.5 % by weight of the polysaccharide or derivative thereof. Preferably the polysaccharide is starch, amylose, amylopectin, glycogen, pectin or a mixture thereof. The polysaccharide may be derived from any suitable source, such as plants, animals, fungi or bacteria. A preferred source are plants, such as potatoes, corn, cereal, rice, algea or apples.

In various embodiments, the amount of the polysaccharide is in the range of between from about 0.002 to about 0.1% by weight of the etching liquid. In further embodiments, the amount lies in the range of between from 0.003 to about 0.05 % by weight of the etching liquid.

In various embodiments, the etching liquid comprises both, at least one polysaccharide or derivative thereof and at least one polyalcohol comprising at least four hydroxy groups or a derivative thereof.

In various embodiments of the invention, the polyalcohol or polyalcohol derivative may be selected from the group consisting of linear, branched or cyclic C₄-C₁₈ polyalcohols including at least four hydroxy groups or derivatives thereof.

In one embodiment, the polyalcohol is selected from the group consisting of sorbitol (glucitol), mannitol, xylitol, maltitol, lactitol, erythritol, arabitol, isomalt, threitol, ribitol, dulcitol, iditol, polyglycitol, inositol, volemitol and mixtures thereof.

In another embodiment, the organic compound is a polyalcohol derivative. The polyalcohol derivative may be an oxidized derivative of a polyalcohol, wherein at least one hydroxy group is replaced by an oxo (=O) group, including but not limited to ketones, aldehydes and carboxylic acids. The derivative may itself include two or more, e.g. three or more, e.g. four or more hydroxy groups.

In various embodiments, the polyalcohol derivative is a carbohydrate, including, but not limited to a monosaccharide, disaccharide, trisaccharide, oligosaccharide or mixtures thereof. The disaccharide, trisaccharide and oligosaccharide may consist of one type of monomers (monosaccharide) or two or more different types of monomers (monosaccharides).

In various embodiments, the carbohydrate may be a non-reducing sugar. This non-reducing sugar may be selected from the group consisting of sucrose, trehalose, raffinose and mixtures thereof.

In various embodiments, the carbohydrate is not a reducing sugar, such as monosaccharides like glucose, fructose, and lactose.

In another embodiment of the invention, the polyalcohol derivative is a sugar acid or salt thereof. The sugar acid may be selected from the group consisting of xylonic acid, gluconic acid, ascorbic acid, glucuronic acid, galacturonic acid, iduronic acid, tataric acid, mucic acid, saccharic acid, alginic acid and mixtures and salts thereof.

In various embodiments, the etching liquid can comprise two or more polysaccharides or derivatives thereof and/or two or more polyalcohols or derivatives thereof.

In various embodiments, the etching solution contains about 0.05 to about 20 % by weight, e.g. about 0.5 to about 10 % by weight, e.g. about 1 to about 10 % by weight, e.g. about 1.5 to about 5 % by weight of the polyalcohol or derivative thereof or, alternatively, about 0.05 to about 3 % by weight, e.g. about 0.1 to about 2.5 % by weight, e.g. about 0.2 to about 2 % by weight.

In various embodiments, if the etching solution contains both, a polysaccharide and a polyalcohol or derivative thereof, the concentration of the polyalcohol or derivative thereof may be about 0.05 to about 3 % by weight, e.g. about 0.1 to about 2.5 % by weight, e.g. about 0.2 to about 2 % by weight. In such embodiments, , the amount of the polysaccharide in the etching liquid may be in the range of between about 0.001 and about 0.5 % by weight, for example between about 0.001 and about 0.05 % by weight or between 0.001 and 0.01 % by weight.

Exemplary combinations of polysaccharides and polyalcohols or derivatives thereof include, but are not limited to starch and any one or more of trehalose, sucrose and raffinose or pectin and any one or more of trehalose, sucrose and raffinose. In one embodiment, the etching liquid contains about 0.004 % by weight or about 0.006 % by weight starch and about 0.2 or 0.3 % by weight sucrose. In another embodiment, the etching liquid contains about 0.004 % by weight pectin and about 0.4 % by weight sucrose. In still further embodiments, the etching liquid contains about 0.01 % by weight starch and about 1 % by weight trehalose. In a still further embodiment, the etching liquid contains about 0.014 % by weight starch and about 1.7 % by weight raffinose. In another embodiment, the etching liquid contains about 0.02 % by weight starch and about 1.5 % by weight sucrose.

The alkaline etching agent may be selected from the group consisting of sodium hydroxide, potassium hydroxide, potassium carbonate, sodium carbonate, calcium hydroxide, tetramethylammonium hydroxide, ethylenediamine pyrocatechol and mixtures thereof. In a preferred embodiment, the alkaline etching agent is sodium hydroxide or potassium hydroxide, preferably potassium hydroxide.

In various embodiments, the etching solution contains about 0.25 to about 15 % by weight, preferably about 0.5 to about 7 % by weight of the alkaline etching agent.

In various embodiments, the etching solution may further include at least one surfactant. The surfactant may be selected from the group comprising but not limited to sodium lauryl sulfate, polyethylene glycol, polyethylene glycol octylphenyl ether and mixtures thereof. The surfactant may be present in a concentration of about 1 to about 20 % by weight, e.g. of about 2 to about 10 % by weight of the etching solution.

The etching solutions of various embodiments may further include one or more auxiliaries which are known to those skilled in the art. Exemplary auxiliaries may include but are not limited to viscosity-controlling agents and the like. Further auxiliaries that may be used to control the size of the pyramidal shapes generated by texture etching are gaseous agents, such as air, oxygen, ozone, and nitrogen, which may be solved in the etching solution.

In various embodiments, the etching solution may be prepared with degassed water to control the size of the pyramidal shapes on the silicon wafer surface.

Exemplary etching liquids of various embodiments may include but are not limited to aqueous solutions, colloids or suspensions of about 0.25 to about 5 wt.-%, preferably about 0.5 to about 3 wt.-% potassium hydroxide or sodium hydroxide and about 0.001 to about 0.5 wt.-% of a polysaccharide, such as starch, amylose, amylopectin, glycogen or pectin. In one specific example, the solution further includes 0.05 to about 3 wt.-% of a non-reducing sugar, such as sucrose, trehalose or raffinose, or sugar alcohol, such as xylitol, mannitol or sorbitol, or inositol.

Further exemplary etching solutions of various embodiments may include but are not limited to aqueous solutions of about 0.25 to about 5 wt.-%, preferably about 0.5 to about 3 wt.-% potassium hydroxide or sodium hydroxide and about 2 to about 10, e.g. about 2.5 to about 9 wt.-% of a non-reducing sugar, such as sucrose, trehalose or raffinose, a sugar alcohol, such as xylitol, mannitol or sorbitol, or inositol.

Due to the presence of an alkaline agent and the basic nature of the etching liquid, the invention encompasses various embodiments where the polysaccharides used are at least partially hydrolyzed to lower molecular weight fragments of the polysaccharide. One specific example is the hydrolysis of starch or glycogen to dextrins.

Various embodiments relate to a process for etching of a silicon wafer, including contacting the silicon wafer with an etching liquid according to various embodiments. This etching may be texture etching and/or damage etching.

In various embodiments of this process, the etching liquid has a temperature of about 60 to about 85 °C, e.g. of about 60 to about 80 °C, e.g. of about 65 to about 75 °C. In other embodiments, the etching liquid has a temperature of about 70 to about 95 °C, e.g. of about 72 to about 90 °C, e.g. of about 72 to about 80 °C, e.g. of about 72 to about 85 °C.

The contacting may include spraying or dripping the etching solution onto the silicon wafer or immersing the wafer in the etching solution.

The contacting time of the silicon wafer with the etching solution is in the range of about 5 to about 25 minutes, e.g. from about 10 to about 15 minutes.

In various embodiments of this process, the etching liquid is stirred, circulated or agitated, for example by a stirrer, ultrasonic, shaker or pump. This may facilitate the diffusion of the etching agents to the wafer surface and the diffusion of reaction products away from the wafer surface and the maintainence of a constant reaction temperature.

The etching process may be carried out as an in-line process or as an batch process. In various embodiments, the etching process of the present invention can be carried out prior to or after another etching process, for example to optimize the etching results. The other etching process may be a convential etching process as it is known in the art.

Various embodiments are directed to a silicon wafer obtained according to the process as described above.

Also encompassed by various embodiments are photovoltaic cells including the silicon wafer according to various embodiments.

Various embodiments are directed to the use of the etching liquid of the invention for texturing the surface of a silicon wafer.

Using the invented etching liquids for the texture etching of silicon wafers, either as cut or saw damage etched or surface-polished prior to texture etching, a high coverage of uniform pyramidal structures can be formed on the surface of the silicon wafer. The resulting wafers may have a high light absorbance.

In one embodiment of the above processes and uses, the silicon wafer used in the process may be a monocrystalline silicon wafer or polycrystalline (multicrystalline) silicon wafer.

The silicon wafer may be a saw damaged silicon wafer (silicon wafer as cut), a silicon wafer that has already been subjected to an etching step to remove saw damage ("damage etched silicon wafer") or a polished silicon wafer.

### Examples

The following example serves as a means to illustrate the various embodiments and should not be construed as limiting the scope of protection of the various embodiments.

Example 1:

Monocrystalline silicon wafers were laser cut into 30 mm x 30 mm squares. The etching solution was prepared in 1 L beakers on a temperature controlled hot plate stirrer and heated to 75 or 80 °C. For texture etching, 4 wafer squares - two as cut and two saw damage etched prior to texture etching - were fixed to a carrier and completely immersed in the etching solution contained in the beaker. The following etching solutions were used:

Solution A: 2.5 wt.-% sucrose, 3 wt.-% NaOH;

Solution B: 3 wt.-% trehalose, 3 wt.-% NaOH;

Solution C: 9 wt.-% raffinose, 3 wt.-% NaOH;

The results obtained with each of these solutions at different etch times are listed in Table 1 below.

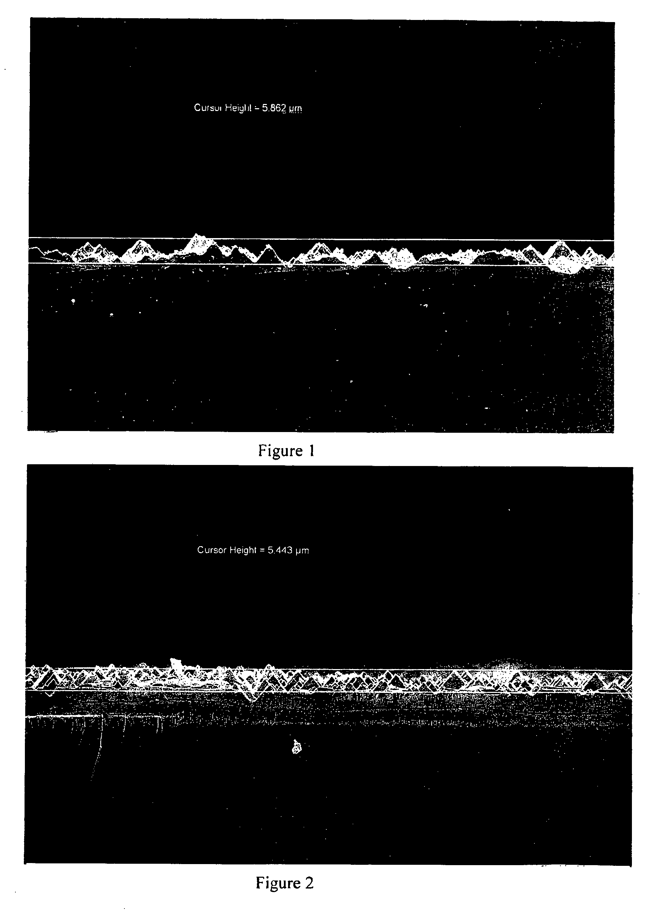

The pyramidal shapes generated on the wafer surface by the texture etching solution and process of the invention using Solution C is shown, by way of example, in the SEM images of the wafer surface in Figures 1 (wafer as cut) and 2 (saw damage etched wafer). Similar pyramidal shapes were generated using Solutions A and B.

**Table 1**

| Solution | Etch time | Temperature | Total removal (µm) | |
|---|---|---|---|---|
| | (min) | (°C) | Wafers damage etched | Wafers as cut |
| A | 15 | 75 | 7.0 | 16.9 |
| A | 20 | 75 | 6.4 | 15.9 |
| A | 30 | 75 | 6.8 | 18.6 |
| B | 15 | 75 | 9.4 | 15.4 |
| B | 20 | 75 | 11.4 | 17.7 |
| C | 15 | 75 | 11.6 | 16.2 |
| C | 20 | 75 | 13.8 | 17.8 |

Example 2:

Monocrystalline silicon wafers were laser cut into 30 mm x 30 mm squares. The etching solution was prepared in 1 L beakers on a temperature controlled hot plate stirrer and heated to 72 or 80 °C. For texture etching, 4 wafer squares - two as cut and two saw damage etched prior to texture etching - were fixed to a carrier and completely immersed in the etching solution contained in the beaker. The following etching solution was used: 3.0 wt.-% Sorbitol, 2.4 wt.-% NaOH.

The results obtained with this solution at different etch times and temepratures are listed in Table 2 below.

**Table 2**

| Etch time | Temperature | Total removal (µm) | |
|---|---|---|---|
| (min) | (°C) | Wafers damage etched | Wafers as cut |
| 10 | 77 | 7.3 | 12.2 |
| 15 | 72 | 8.5 | 13.4 |

Example 3:

Monocrystalline silicon wafers were laser cut into 30 mm x 30 mm squares. The etching liquid was prepared in 1 L beakers on a temperature controlled hot plate stirrer and heated to the desired temperature in the range of between 59.5 and 77 °C. The alkaline etching liquid was prepared by adding a defined amount of an alkaline stock solution containing 2 % by weight starch or pectin and 3 % by weight potassium hydroxide (KOH) to an alkaline solution containing 3 % by weight KOH. The amount of the stock solution used was dependent on the desired end concentration of the polysaccharide in the etching liquid. For texture etching, 4 wafer squares - two as cut and two saw damage etched prior to texture etching - were fixed to a special Teflon carrier and completely immersed in the etching liquid contained in the beaker. The beaker was sealed by an acrylic lid to reduce evaporation. After completion of the etching process the loaded carrier was neutralized in a cold water beaker to stop the reaction and then rinsed with water.

The results obtained with different etching liquids according to the invention at different etch times and different temperatures are listed in Tables 1-5 below.

**Table 1**

| **Starch in 3 % KOH** | | | | | |
|---|---|---|---|---|---|
| | Starch | *Etch Time* | *Temperature* | *Total Removal (um)* | |
| | (wt. %) | *(minutes)* | (*°C*) | *damage etched* | *as cut* |
| | *0.04* | *9* | *73.5* | *9.6* | *13.4* |
| | *0.05* | *5* | *73.5* | *6.2* | *10.1* |
| | *0.06* | *5* | *74.0* | *5.4* | *8.8* |

**Table 2**

| **Combination of Starch and Sucrose in 3% KOH** | | | | | |
|---|---|---|---|---|---|
| Starch | Sucrose (Powder Sugar) | Process Temp. | Etch Time | Total Removal (um) | |
| (%)wt | (%)wt | °C | (Minutes) | Wafer as cut | Wafer damage etched |
| 0.004 | 0.2 | 74.0C | 10 | 22.0 | 16.1 |
| 0.006 | 0.3 | 76.0C | 6 | 12.4 | 8.2 |

**Table 3**

| **Combination of Starch and Sucrose in 3% KOH** | | | | | |
|---|---|---|---|---|---|
| Starch | Sucrose (Powder Sugar) | Process Temp. | Etch Time | Total Removal (um) | |
| (%)wt | (%)wt | °C | (Minutes) | Wafer as cut | wafer damage etched |
| 0.006 | 0.3 | 59.5 | 20 | 12.5 | 8.4 |
| 0.006 | 0.3 | 60.0 | 15 | 12.1 | 7.5 |

**Table 4**

| **Combination: Starch and Suc rose in 3% KOH Texture Solution** | | | | | |
|---|---|---|---|---|---|
| Starch | Sucrose (cryst.) | Process Temp. | Etch Time | Total Removal (um) | |
| (%) | % | (°C) | (minutes) | Wafer as cut | Wafer dam. etched |
| 0.01 | 1.5 | 75.5 | 10 | 16.0 | 11.5 |
| | | | | | |

| **Combination: Starch and Raffi nose in 3% KOH Texture solution** | | | | | |
|---|---|---|---|---|---|
| Starch | Raffinose | Process Temp. | Etch Time | Total Removal (um) | |
| (%) | % | (°C) | (Minutes) | Wafer as cut | Wafer dam. etched |
| 0.014 | 1.7 | 74.5 | 10 | 18.0 | 13.5 |
| | | | | | |

| **Combination: Starch and Treh alose in 3% KO H Texture Solution** | | | | | |
|---|---|---|---|---|---|
| Starch | Trehalose | Process Temp. | Etch Time | Total Removal (um) | |
| (%) | % | (°C) | (Minutes) | Wafer as cut | Wafer dam. etched |
| 0.01 | 1.0 | 75.5 | 10 | 19.0 | 11.8 |

**Table 5**

| Pektin in 3% KOH Texture Solution | | | | | |
|---|---|---|---|---|---|
| Pectin | | Process Temp. | Etch Time | Total Removal (um) | |
| (%) | | (°C) | (Minutes) | Wafer as cut | Wafer dam. etched |
| 0.004 | | 74.5 | 6 | 15.5 | 9.3 |
| | | | | | |

| Combination: Pectin and Sucrose (crystalline) in 3% KOH Texture Solution | | | | | |
|---|---|---|---|---|---|
| Pectin | Sucrose | Process Temp. | Etch Time | Total Removal (um) | |
| (%) | % | (°C) | (Minutes) | Wafer dam. etched | |
| 0.004 | 0.4 | 77.0 | 10 | 12.0 | |

Scanning electron microscope (SEM) images of a silicon wafer surface as cut after texture etching for 9 minutes with an aqueous solution of 0.04 wt.-% starch and 3 wt.-% KOH at 73.5 °C or a silicon wafer surface that was first damage etched and then texture etched for 6 minutes with an aqueous solution of 0.004 wt.-% pectin and 3 wt.-% KOH at 73.5 °C are shown in Figures 1 and 2, respectively.

Example 4:

2000 damage etched monocrystalline silicon wafers were texture etched in an aqueous etching liquid containing 0.04 % by weight starch and 3 % by weight KOH. The texture etching was carried out for 12 minutes at 74 °C. One reference of wafers as cut, i.e. without previous saw damage etching, was also tested under the same conditions. The results are shown in Table 6.

**Table 6**

| | | **pre** | **post** | **Total Removal** | |
|---|---|---|---|---|---|
| **Ref Wafer** | **#** | **(g)** | **(g)** | **(g)** | **(um)** |
| as cut | 44 | 11.3414 | 10.3213 | 1.0201 | **18.3** |
| as cut | 45 | 11.3614 | 10.3590 | 1.0024 | **18.0** |
| as cut | 46 | 11.0228 | 9.9732 | 1.0496 | **18.8** |
| dam etched | 1 | 10.4805 | 9.9208 | 0.5597 | **10.0** |
| dam etched | 2 | 10.4560 | 9.8963 | 0.5597 | **10.0** |
| dam etched | 3 | 10.5802 | 10.0197 | 0.5605 | **10.1** |

The performance of the thus produced wafers was tested and compared to conventionally prepared wafers. It was found that the electrical performance of the produced solar cells remained the same. (data not shown).

Various embodiments generally relate to an etching liquid for texturing a silicon surface, the etching liquid including an alkaline etching agent and at least one polysaccharide and/or at least one polyalcohol or derivative thereof as well as the use thereof for texturing a silicon surface. Also encompassed by various embodiments are processes for the etching of a silicon wafer using the etching liquids according to various embodiments, the thus obtained silicon wafers and photovoltaic cells including such wafers.

Various embodiments may meet the above need and may provide an etching liquid for texturing a silicon wafer surface including an additive that is less prone to evaporation during the etching process, inexpensive and relatively non-toxic, but still provides for rapid etching at temperatures below 80 °C.

Various embodiments are directed to an etching liquid for texturing a silicon wafer surface including an aqueous solution of at least one alkaline etching agent and at least one polysaccharide or derivative thereof and/or including at least one polyalcohol comprising at least four hydroxy groups or a derivative thereof.

Various embodiments relate to a process for etching of a silicon wafer, including contacting the silicon wafer with an etching liquid according to various embodiments. This etching may be texture etching only or texture etching that includes damage etching. This etching may also be performed as a second etching step subsequent to a first etching process, for example to optimize the results obtained in the first etching or to generate different textures on the silicon wafer surface.

Various embodiments may be directed to a silicon wafer obtained according to the process of various embodiments or a photovoltaic cell including such a wafer.

Various embodiments may be directed to the use of the etching liquid of various embodiments for texturing the surface of a silicon wafer.

## Claims

1. An etching liquid for at least one of texturing a silicon wafer surface, the etching liquid comprising:
an aqueous solution, colloid or suspension of at least one alkaline etching agent and
(i) at least one polysaccharide or a derivative thereof, wherein (1) the polysaccharide is selected from the group consisting of starch, amylose, amylopectin, glycogen, alginate, carrageenans, agarose, agaropectin, pectin, chitin, beta-glucans, dextrins, carboxymethylcellulose, carboxyethylcellulose, hydroxypropylcellulose, methylcellulose and combinations thereof; and (2) the solution contains about 0.001 % to about 0.5 % by weight of the at least one polysaccharide or derivative thereof, and
(ii) at least one polyalcohol comprising at least four hydroxy groups or a derivative thereof.

2. The etching liquid according to claim 1, wherein
the etching liquid comprises at least one polysaccharide or a derivative thereof and at least one polyalcohol comprising at least four hydroxy groups or a derivative thereof.

3. The etching liquid according to any one of claims 1-2, wherein
(1) the polyalcohol or polyalcohol derivative is selected from the group consisting of linear, branched or cyclic C4-C18 polyalcohols comprising at least four hydroxy groups or derivatives thereof;
(2) the polyalcohol is selected from the group consisting of sorbitol, mannitol, inositol, xylitol, maltitol, lactitol, erythritol, arabitol, isomalt, threitol, ribitol, dulcitol, iditol, polyglycitol, inositol, volemitol and mixtures thereof;
(3) the polyalcohol derivative is a carbohydrate;
(4) the polyalcohol derivative is a carbohydrate selected from the group consisting of monosaccharides, disaccharides, trisaccharides, oligosaccharides and mixtures thereof;
(5) the polyalcohol derivative is a non-reducing sugar;
(6) the polyalcohol derivative is a non-reducing sugar selected from the group consisting of sucrose, trehalose, raffinose and mixtures thereof;
(7) the polyalcohol derivative is a sugar acid or salt thereof; or
(8) the polyalcohol derivative is a sugar acid selected from the group consisting of xylonic acid, gluconic acid, ascorbic acid, glucuronic acid, galacturonic acid, iduronic acid, tataric acid, mucic acid, saccharic acid, alginic acid and mixtures and salts thereof.

4. The etching liquid according to any one of claims 1-3, the etching liquid contains about 0.05 % to about 3 % by weight of the polyalcohol or derivative thereof.

5. The etching liquid according to any one of claims 1-4, wherein the alkaline etching agent is selected from the group consisting of sodium hydroxide, potassium hydroxide, potassium carbonate, sodium carbonate, calcium hydroxide, tetramethylammonium hydroxide, ethylenediamine pyrocatechol and mixtures thereof.

6. The etching liquid according to any one of claims 1-5, wherein the etching liquid contains about 0.5 to about 7 % by weight of the alkaline etching agent.

7. The etching liquid according to any one of claims 1-6, wherein the etching liquid further comprises at least one surfactant.

8. The etching liquid according to claim 7, wherein the surfactant is selected from the group consisting of sodium lauryl sulfate, polyethylene glycol, polyethylene glycol octylphenyl ether and mixtures thereof.

9. The etching liquid according to claim 7-8, wherein the etching liquid contains about 1 to about 20 % by weight of the surfactant.

10. An etching process for texturing a silicon wafer, the process comprising:
contacting the silicon wafer with an etching liquid according to any one of claims 1-9,

11. The process according to claim 10, wherein
(1) the contacting comprises immersing the silicon wafer in the etching liquid; and/or
(2) the etching liquid has a temperature of about 60 to about 85 °C; and/or
(3) the silicon wafer is contacted with the etching liquid for about 5 to about 25 minutes; and/or
(4) the silicon wafer is a monocrystalline silicon wafer or multicrystalline silicon wafer; and/or
(5) the silicon wafer is a wafer selected from a group consisting of a saw damaged silicon wafer; a damage etched silicon wafer; and a polished silicon wafer; and/or
(6) the process is an in line or batch process.

12. Use of the etching liquid of any one of claims 1-9 for etching of a silicon wafer.

## Patentansprüche

1. Eine Ätzflüssigkeit für mindestens eines von: Texturierung einer Oberfläche eines Siliziumwafers, wobei die Ätzflüssigkeit umfasst:
eine wässrige Lösung, Kolloid oder Suspension mindestens eines alkalischen Ätzmittels und
(i) mindestens ein Polysaccharid oder ein Derivat davon, wobei (1) das Polysaccharid ausgewählt ist aus der Gruppe bestehend aus Stärke, Amylose, Amylopektin, Glykogen, Alginat, Carrageen, Agarose, Agaropektin, Pektin, Chitin, beta-Glucanen, Dextrinen, Carboxymethylcellulose, Carboxyethylcellulose, Hydroxypropylcellulose, Methylcellulose und Kombinationen davon; und (2) die Lösung etwa 0,001 % bis etwa 0,5 Gew.% des mindestens einen Polysaccharids oder Derivats davon enthält, und
(ii) mindestens einen Polyalkohol mit mindestens vier Hydroxygruppen oder ein Derivat davon.

2. Die Ätzflüssigkeit nach Anspruch 1, wobei die Ätzflüssigkeit mindestens ein Polysaccharid oder ein Derivat davon und mindestens einen Polyalkohol mit mindestens vier Hydroxygruppen oder ein Derivat davon umfasst.

3. Die Ätzflüssigkeit nach Anspruch 1 oder 2, wobei
(1) der Polyalkohol oder das Polyalkohol-Derivat ausgewählt ist aus der Gruppe bestehend aus linearen, verzweigten oder cyclischen C4-C 18 Polyalkoholen, die mindestens vier Hydroxy-Gruppen umfassen oder Derivaten davon;
(2) der Polyalkohol ausgewählt ist aus der Gruppe bestehend aus Sorbit, Mannit, Inosit, Xylit, Maltit, Lactitol, Erythrit, Arabitol, Isomalt, Threit, Ribit, Dulcit, Idit, Polyglycitol, Inosit, Volemitol und Mischungen davon;
(3) das Polyalkohol-Derivat ein Kohlenhydrat ist;
(4) das Polyalkohol-Derivat ein Kohlenhydrat ist ausgewählt aus der Gruppe bestehend aus Monosacchariden, Disacchariden, Trisacchariden, Oligosacchariden und Mischungen davon;
(5) das Polyalkohol-Derivat ein nicht reduzierender Zucker ist;
(6) das Polyalkohol-Derivat ein nicht reduzierender Zucker ist ausgewählt aus der Gruppe bestehend aus Saccharose, Trehalose, Raffinose und Mischungen davon ist;
(7) das Polyalkohol Derivat eine Zuckersäure oder ein Salz davon ist; oder
(8) das Polyalkohol Derivat eine Zuckersäure ist ausgewählt aus der Gruppe bestehend aus Xylonsäure, Gluconsäure, Ascorbinsäure, Glucuronsäure, Galacturonsäure, Iduronsäure, Weinsäure, Schleimsäure, Zuckersäure, Alginsäure und deren Gemische und deren Salze.

4. Die Ätzflüssigkeit nach einem der Ansprüche 1 bis 3, wobei die Ätzflüssigkeit etwa 0,05% bis etwa 3 Gew.% des Polyalkohols oder Derivates davon umfasst.

5. Die Ätzflüssigkeit nach einem der Ansprüche 1 bis 4, wobei das alkalische Ätzmittel ausgewählt ist aus der Gruppe bestehend aus Natriumhydroxid, Kaliumhydroxid, Kaliumcarbonat, Natriumcarbonat, Calciumcarbonat, Tetramethylammoniumhydroxid, Ethylendiaminpyrokatechol und Mischungen davon.

6. Die Ätzflüssigkeit nach einem der Ansprüche 1 bis 5, wobei die Ätzflüssigkeit etwa 0,5 bis etwa 7 Gew.% des alkalischen Ätzmittels umfasst.

7. Die Ätzflüssigkeit nach einem der Ansprüche 1 bis 6, wobei die Ätzflüssigkeit ferner mindestens ein Tensid umfasst.

8. Die Ätzflüssigkeit nach Anspruch 7, wobei das Tensid ausgewählt ist aus der Gruppe bestehend aus Natriumlaurylsulfat, Polyethylenglycol, Polyethylenglycoloctylphenylether und Mischungen davon.

9. Die Ätzflüssigkeit nach Anspruch 7 oder 8, wobei die Ätzflüssigkeit etwa 1 bis etwa 20 Gew.% des Tensids umfasst.

10. Ein Ätzverfahren zur Texturierung eines Siliziumwafers, wobei das Verfahren umfasst:
Kontaktieren des Siliziumwafers mit einer Ätzflüssigkeit nach einem der Ansprüche 1 bis 9.

11. Verfahren nach Anspruch 10, wobei
(1) das Kontaktieren das Eintauchen des Siliziumwafers in die Ätzflüssigkeit umfasst; und/oder
(2) die Ätzflüssigkeit eine Temperatur von etwa 60 bis etwa 85 °C aufweist; und/oder
(3) der Siliziumwafer mit der Ätzflüssigkeit für etwa 5 bis etwa 25 Minuten in Kontakt gebracht wird; und/oder
(4) der Siliziumwafer ein monokristalliner Siliziumwafer oder ein multikristalliner Siliziumwafer ist; und/oder
(5) der Siliziumwafer ein Wafer ist ausgewählt aus der Gruppe bestehend aus einem Siliziumwafer mit Sägeschäden, einem Sägeschaden geätzten Siliziumwafer und einem polierten Siliziumwafer; und/oder
(6) das Verfahren ein in-line Verfahren oder ein Batch Verfahren ist.

12. Verwendung der Ätzflüssigkeit nach einem der Ansprüche 1 bis 9 zum Ätzen eines Siliziumwafers.

## Revendications

1. Liquide de gravure pour au moins texturer une surface d'une tranche de silicium, le liquide de gravure comprenant :
une solution aqueuse, un colloïde ou une suspension d'au moins un agent de gravure alcalin et
(i) au moins un polysaccharide ou dérivé de celui-ci, dans lequel (1) le polysaccharide est choisi dans le groupe constitué par l'amidon, l'amylose, l'amylopectine, le glycogène, l'alginate, les carraghénines, l'agarose, l'agaropectine, la pectine, la chitine, les bêta-glucanes, les dextrines, la carboxyméthylcellulose, la carboxyéthylcellulose, l'hydroxypropylcellulose, la méthylcellulose et leurs combinaisons ; et (2) la solution contient environ 0,001 % à environ 0,5 % en poids dudit au moins polysaccharide ou dérivé de celui-ci, et
(ii) au moins un polyol comprenant au moins quatre groupes hydroxy ou dérivé de celui-ci.

2. Liquide de gravure selon la revendication 1, dans lequel
le liquide de gravure comprend au moins un polysaccharide ou dérivé de celui-ci et au moins un polyol comprenant au moins quatre groupes hydroxy ou dérivé de celui-ci.

3. Liquide de gravure selon l'une quelconque des revendications 1 ou 2, dans lequel
(1) le polyol ou dérivé de polyol est choisi dans le groupe constitué par les polyols C4-C18 linéaires, ramifiés ou cycliques comprenant au moins quatre groupes hydroxy ou leurs dérivés ;
(2) le polyol est choisi dans le groupe constitué par le sorbitol, le mannitol, l'inositol, le xylitol, le maltitol, le lactitol, l'érythritol, l'arabitol, l'isomalt, le thréitol, le ribitol, le dulcitol, l'iditol, le polyglycitol, l'inositol, le volémitol et leurs mélanges ;
(3) le dérivé de polyol est un glucide ;
(4) le dérivé de polyol est un glucide choisi dans le groupe constitué par les monosaccharides, les disaccharides, les trisaccharides, les oligosaccharides et leurs mélanges ;
(5) le dérivé de polyol est un sucre non réducteur ;
(6) le dérivé de polyol est un sucre non réducteur choisi dans le groupe constitué par le saccharose, le tréhalose, le raffinose et leurs mélanges ;
(7) le dérivé de polyol est un acide de sucre ou son sel ; ou
(8) le dérivé de polyol est un acide de sucre choisi dans le groupe constitué par l'acide xylonique, l'acide gluconique, l'acide ascorbique, l'acide glucuronique, l'acide galacturonique, l'acide iduronique, l'acide tartrique, l'acide mucique, l'acide saccharique, l'acide alginique, leurs mélanges et leurs sels.

4. Liquide de gravure selon l'une quelconque des revendications 1 à 3, dans lequel le liquide de gravure contient environ 0,05 % à environ 3 % en poids de polyol ou de son dérivé.

5. Liquide de gravure selon l'une quelconque des revendications 1 à 4, dans lequel l'agent de gravure alcalin est choisi dans le groupe constitué par l'hydroxyde de sodium, l'hydroxyde de potassium, le carbonate de potassium, le carbonate de sodium, l'hydroxyde de calcium, l'hydroxyde de tétraméthylammonium, l'éthylènediamine pyrocatéchol et leurs mélanges.

6. Liquide de gravure selon l'une quelconque des revendications 1 à 5, dans lequel le liquide de gravure contient environ 0,5 à environ 7 % en poids de l'agent de gravure alcalin.

7. Liquide de gravure selon l'une quelconque des revendications 1 à 6, dans lequel le liquide de gravure comprend en outre au moins un tensioactif.

8. Liquide de gravure selon la revendication 7, dans lequel le tensioactif est choisi dans le groupe constitué par le laurylsulfate de sodium, le polyéthylène glycol, l'éther octylphénylique du polyéthylène glycol et leurs mélanges.

9. Liquide de gravure selon la revendication 7 ou 8, dans lequel le liquide de gravure contient environ 1 à environ 20 % en poids de tensioactif.

10. Procédé de gravure pour texturer une tranche de silicium, le procédé comprenant :
la mise en contact de la tranche de silicium avec un liquide de gravure selon l'une quelconque des revendications 1 à 9.

11. Procédé selon la revendication 10, dans lequel
(1) la mise en contact comprend l'immersion de la tranche de silicium dans le liquide de gravure ; et/ou
(2) le liquide de gravure a une température d'environ 60 à environ 85°C ; et/ou
(3) la tranche de silicium est mise en contact avec le liquide de gravure pendant environ 5 à environ 25 minutes ; et/ou
(4) la tranche de silicium est une tranche de silicium monocristallin ou une tranche de silicium multicristallin ; et/ou
(5) la tranche de silicium est une tranche choisie dans le groupe constitué par une tranche de silicium endommagée par une scie ; une tranche de silicium gravée endommagée ; et une tranche de silicium polie ; et/ou
(6) le procédé est un procédé continu ou discontinu.

12. Utilisation du liquide de gravure selon l'une quelconque des revendications 1 à 9 pour graver une tranche de silicium.
